# EUROPEAN PATENT APPLICATION

(11) **EP 4 737 609 A1**
(43) Date of publication of application: **06.05.2026**
(21) Application number: 24830865.2
(22) Date of filing: 27.06.2024
(51) Int. Cl.: C23C 14/54, C23C 14/56, H01L 21/67, H01L 21/677

(54) **PROCESS MODULE, SEMICONDUCTOR PROCESS DEVICE AND THIN FILM DEPOSITION METHOD**

(30) Priority: 30.06.2023 CN 202310797727
(71) Applicant: Beijing NAURA Microelectronics Equipment Co., Ltd., Beijing 100176 (CN)
(72) Inventor: ZHANG, Shihao, Beijing 100176 (CN); SHE, Qing, Beijing 100176 (CN); LI, Bing, Beijing 100176 (CN)
(74) Representative: Cohausz & Florack
(86) International application number: PCT/CN2024/101917
(87) International publication number: WO 2025/002232

(57) **Abstract**

A process chamber, a semiconductor processing apparatus, and a thin film deposition method are provided. This process chamber comprises a reaction chamber, a heating chamber, and a transmission device. A base for supporting a wafer is provided in the reaction chamber. The heating chamber is in communication with the reaction chamber, and a thermal radiation device is provided at a top of the heating chamber and is used for radiating heat toward an interior of the heating chamber. The transmission device is provided in the reaction chamber and is used for supporting the wafer and transmitting the wafer between the reaction chamber and the heating chamber. The presently disclosed process chamber, semiconductor processing apparatus, and thin film deposition method can improve heating efficiency and heating uniformity of the wafer.

## Description

### FIELD OF THE INVENTION

The present disclosure relates to the field of semiconductor manufacturing, and in particular, to a process chamber, a semiconductor processing apparatus, and a thin film deposition method.

### BACKGROUND OF THE INVENTION

Magnetron sputtering is a widely used Physical Vapor Deposition (PVD) technique in the semiconductor industry, especially for thin-film fabrication. As integrated circuits continue to evolve, copper has become the preferred material for back-end-of-line (BEOL) interconnects due to its lower resistivity, which helps reduce power loss and resistance-capacitance (RC) caused delay, ultimately boosting chip performance.

In today's copper interconnect process, copper's resistance to etching makes the process for dual-damascene structure widely used. This approach involves etching vias and trenches into the inter-metal dielectric layer, followed by PVD deposition of a barrier layer (such as TiN) into the vias and trenches and a copper seed layer on the barrier layer. Bulk copper is then deposited into the vias and trenches through an electrochemical plating process. However, as device dimensions shrink and trench depth-to-width ratio increase, when depositing copper, copper atoms do not all deposit layer by layer strictly perpendicular to the trench bottom. Instead, they tend to accumulate more rapidly near the upper opening, leading to overhangs or even blockages. This can trap voids at the bottom of the trench, degrading the chip's electrical performance. To address this problem, typically a copper reflow process is introduced after depositing the barrier layer and the seed layer. At the nanoscale, copper's melting point decreases with copper particle size, while the copper particle surface energy and tension increase. By heating the copper to 300°C or higher, the molten copper atoms are driven by surface tension and capillary forces to migrate into the trench bottom, improving fill quality.

Current PVD systems often use a thermal radiation source inside the chamber to heat the wafer during the copper reflow. The thermal radiation source is commonly set around the chamber perimeter, which is relatively far from where the wafer is located, resulting in uneven temperature distribution and poor heating efficiency. In another approach the heat source is mounted on the shield disk transfer mechanism, but in this setup, it is a struggle to focus heat on the wafer surface. Much of the thermal energy ends up going toward outside the target area, leading to significant heat loss and suboptimal wafer heating.

### SUMMARY OF THE INVENTION

The present disclosure provides a process chamber, a semiconductor processing apparatus, and a thin film deposition method.

A first embodiment of the present disclosure provides a process chamber, and the process chamber comprises a reaction chamber, a heating chamber, and a transmission device.

A base for carrying a wafer is disposed in the reaction chamber.

The heating chamber is in communication with the reaction chamber. A thermal radiation device is provided at a top of the heating chamber and is configured for radiating heat toward an interior of the heating chamber.

The transmission device is disposed in the reaction chamber for carrying the wafer and is configured to transmit the wafer between the reaction chamber and the heating chamber.

In some embodiments, a shutter disk is further stored in the heating chamber, and the transmission device is further configured to carry the shutter disk and transmit the shutter disk between the reaction chamber and the heating chamber.

In some embodiments, the transmission device is configured to transmit the shutter disk stored in the heating chamber above the base, before a semiconductor process is performed on the wafer in the reaction chamber, and to transmit the shutter disk back to store in the heating chamber when the wafer begins to undergo the semiconductor process; or the transmission device is configured to transmit the wafer below the thermal radiation device after the wafer completes the semiconductor process to enable the thermal radiation device to heat the wafer, and to transmit the wafer back onto the base after the thermal radiation device finishes heating the wafer.

In some embodiments, a top wall of the heating chamber is provided with a reflective surface, and the reflective surface is configured to reflect heat radiated by the thermal radiation device to a surface of the wafer located in the heating chamber.

In some embodiments, a cooling flow channel is arranged on the top wall of the heating chamber, and the cooling flow channel is configured to transmit a cooling fluid.

In some embodiments, a concave portion is formed on the top wall of the heating chamber, an inner surface of the concave portion forms the reflective surface, and a shape of the inner surface of the concave portion is configured to enable reflected light to converge toward the surface of the wafer located in the heating chamber, such that the reflected light covers the entire surface of the wafer.

In some embodiments, the reflective surface comprises a planarized surface and an annular surface surrounding the planarized surface. The planarized surface is parallel to a horizontal plane, and a height of the annular surface decreases from an edge of the planarized surface toward a direction close to a peripheral edge of the top wall of the heating chamber.

In some embodiments, the thermal radiation device comprises at least one annular light tube, and the annular light tube is disposed around an inner side of the annular surface and located outside the edge of the planarized surface.

In some embodiments, the heating chamber comprises a chamber body having an opening at its top, and a reflective plate disposed at the top of the chamber body, The reflective plate is seamlessly connected to the chamber body for sealing the opening, the reflective plate has the reflective surface, and the reflective surface is exposed from the opening into the heating chamber.

In some embodiments, a first annular convex portion is provided at the opening located at the top of the chamber body, a second annular convex portion is provided at an outer peripheral edge of the reflective plate, the second annular convex portion is stacked on the first annular convex portion, and the first annular convex portion is fixedly connected to the second annular convex portion.

A sealing member is further disposed between the first annular convex portion and the second annular convex portion for sealing the opening.

In some embodiments, the process chamber further comprises a first lifting apparatus disposed in the heating chamber. The first lifting apparatus is configured to carry the shutter disk in the heating chamber.

At least one of the first lifting apparatus and the transmission device is configured to drive the shutter disk disposed thereon to ascend or descend, to transmit the shutter disk between the first lifting apparatus and the transmission device.

In some embodiments, when the transmission device is to transmit the wafer to the heating chamber, the first lifting apparatus is configured to drive the shutter disk disposed thereon to descend to a first bearing location, which is lower than a second bearing location where the wafer is to be carried to by the transmission device within the heating chamber.

In some embodiments, the process chamber further comprises a second lifting apparatus disposed in the reaction chamber. The second lifting apparatus is configured to ascend and descend the wafer in the reaction chamber.

At least one of the second lifting apparatus and the base is configured to drive the wafer disposed thereon to transmit the wafer between the second lifting apparatus and the base.

In some embodiments, the transmission device comprises a transmission arm and a second driving source. The transmission arm is configured to carry the shutter disk or the wafer, and the second driving source is configured to drive the transmission arm to move between the reaction chamber and the heating chamber.

The transmission arm comprises a rotating shaft disposed along a vertical direction and a connecting arm and a bearing portion perpendicular to the rotating shaft. A lower end of the rotating shaft is connected to the second driving source, an upper end of the rotating shaft is connected to a first end of the connecting arm, and a second end of the connecting arm is connected to the bearing portion.

The second lifting apparatus comprises pins arranged at intervals along a circumferential direction of the base, and when the bearing portion carries the shutter disk or the wafer to move into the reaction chamber, at least a part of the bearing portion moves into a space enclosed by the pins from an interval between adjacent pins of the second lifting apparatus, such that the shutter disk or the wafer is located above the base.

The first lifting apparatus comprises pins arranged at intervals along a circumferential line, and when the bearing portion carries the shutter disk or the wafer to move into the heating chamber, at least a part of the bearing portion moves into a space enclosed by the pins from an interval between adjacent pins of the first lifting apparatus, such that the shutter disk or the wafer is located below the thermal radiation device.

An embodiment of the present disclosure provides a semiconductor processing apparatus, comprising a process chamber as described in any one of the examples provided in the first embodiment of the present disclosure.

In some embodiments, the semiconductor processing apparatus comprises a physical vapor deposition device.

An embodiment of the present disclosure provides a thin film deposition method, comprising: lowering a shutter disk to a first bearing location in a heating chamber after a wafer in a reaction chamber completes a semiconductor process, where the heating chamber is in communication with the reaction chamber; transmitting the wafer to a second bearing location in the heating chamber, where the second bearing location is higher than the first bearing location; and radiating heat from a top of the heating chamber to perform heating on the wafer.

The present disclosure offers the following beneficial effects.

In the technical solutions of the process chamber, semiconductor processing apparatus, and thin film deposition method provided in the present disclosure, before performing a thermal treatment process such as a metal reflow process, the transmission device can carry the wafer and transmit it from the reaction chamber to the heating chamber. During the thermal treatment process, the thermal radiation device disposed at the top of the heating chamber radiates heat toward the wafer inside the heating chamber, thereby heating the wafer and completing the thermal treatment process. In the present disclosure, the wafer is heated inside the heating chamber. Since the volume of the heating chamber can be configured to be smaller than that of the reaction chamber, the heat distribution can be more concentrated and heat loss can be reduced, thereby improving the wafer heating rate. Meanwhile, by disposing the thermal radiation device at the top of the heating chamber, the upper surface of the wafer can be directly heated, further enhancing the wafer heating rate. In addition, since the reaction chamber and the heating chamber are connected, both the semiconductor process (such as deposition and etching) and the thermal treatment process can be completed within a single process chamber, thereby improving semiconductor manufacturing efficiency.

### BRIEF DESCRIPTION OF DRAWINGS

FIG. 1 is a cross-sectional side view of a physical vapor deposition device according to an example of the present disclosure.
FIG. 2 is a partial enlarged view of a heating chamber in the physical vapor deposition device shown in FIG. 1.
FIG. 3 is a schematic top view of a transmission arm of a transmission device according to an example of the present disclosure.
FIG. 4 is a schematic top view of the transmission arm in a state where a wafer is disposed on the transmission device.
FIG. 5 is a flowchart of a thin film deposition method according to an example of the present disclosure.

### DETAILED DESCRIPTION OF THE INVENTION

To enable those skilled in the art to better understand the present disclosure, the process chamber, semiconductor processing apparatus, and thin film deposition method provided herein are described in detail below with reference to the accompanying drawings.

In the related art, the process chamber comprises a chamber body, a shutter disk garage in communication with the interior of the chamber body, a shutter disk, and a transmission mechanism. A base and an ejector pin mechanism are disposed within the chamber body. The base is used to carry the workpiece during the thin film deposition process. The ejector pin mechanism lifts and lowers to transfer the wafer to and from the base. The transmission mechanism is configured to transmit the shutter disk from the shutter disk garage to a position above the base or wafer when a new target material is used or when the chamber is preheated, thereby preventing contamination of the base or wafer. In the related art, a heating element is disposed on the transmission arm of the transmission mechanism. Taking the copper reflow process as an example, after the copper seed layer deposition process on the wafer is completed, the ejector pin mechanism lifts the wafer to the reflow process position, and the transmission arm rotates to a position below the wafer to heat the backside of the wafer and perform copper reflow. After the reflow process is completed, the transmission arm rotates to the shutter disk garage under the drive of the drive apparatus.

However, in the above reflow process implementation, the heating element on the transmission arm is used to heat the backside of the wafer. On one hand, due to the positional constraints of the ejector pin mechanism that supports the wafer, the tray area of the transmission arm is limited, and the area of the heating element cannot cover the entire backside of the wafer. On the other hand, this heating method makes it difficult to concentrate the radiated heat on the wafer surface, resulting in significant heat loss and low heating efficiency of the wafer.

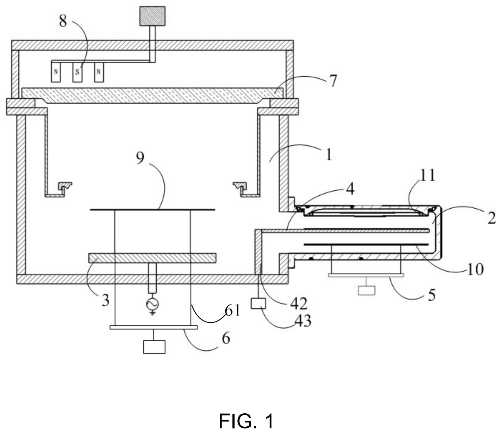

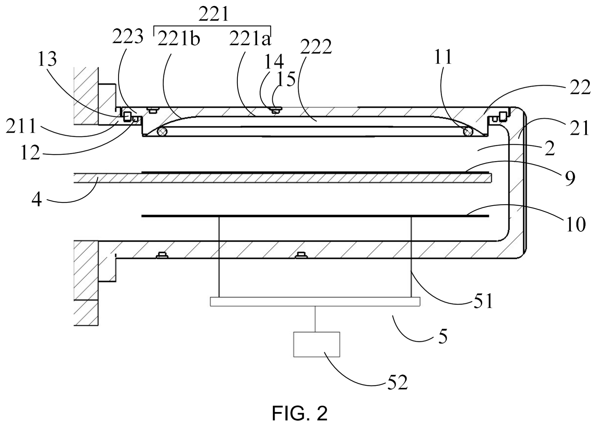

To address the above technical issues, please refer to FIG. 1 and FIG. 2. The process chamber provided in the first embodiment of the present disclosure comprises a reaction chamber 1, a heating chamber 2, and a transmission device 4. A base 3 is disposed within the reaction chamber 1 for carrying a wafer 9. The base 3 may be, for example, an electrostatic chuck. In some examples, the base 3 is also electrically connected to a radio frequency power source to form a radio frequency bias on the surface of the wafer 9. Within the reaction chamber 1, a target 7 is disposed above the base 3. The target 7 is electrically connected to an excitation power source and is configured to excite process gas (e.g., argon) in the reaction chamber 1 to form plasma and bombard the target 7. The target material sputtered from the target 7 moves toward the surface of the wafer 9 under the influence of the radio frequency bias and deposits on the wafer 9 to form a thin film. Additionally, in some examples, a magnetron 8 is disposed above the target 7. The reaction chamber 1 may be applied to the deposition of thin films of copper (Cu), ruthenium (Ru), cobalt (Co), molybdenum (Mo), tungsten (W), rhodium (Rh), titanium (Ti), tantalum (Ta), aluminum (Al), and other materials.

The heating chamber 2 is in communication with the reaction chamber 1. On this basis, a thermal radiation device 11 is disposed at the top of the heating chamber 2 and is configured to radiate heat toward the interior of the heating chamber 2. The transmission device 4 is configured to carry the wafer 9 and transmit the wafer 9 between the reaction chamber 1 and the heating chamber 2. Thus, before performing a thermal treatment process such as a metal reflow process, the transmission device 4 can carry the wafer 9 and transmit it from the reaction chamber 1 to the heating chamber 2. During the thermal treatment process, the thermal radiation device 11 disposed at the top of the heating chamber 2 radiates heat toward the wafer 9 inside the heating chamber 2, thereby heating the wafer 9 and completing the thermal treatment process. In the present disclosure, the wafer 9 is heated within the heating chamber 2. Since the volume of the heating chamber 2 can be configured to be smaller than that of the reaction chamber 1, the heat distribution can be more concentrated and heat loss can be reduced, thereby improving the heating rate of the wafer 9. Meanwhile, by disposing the thermal radiation device 11 at the top of the heating chamber 2, the upper surface of the wafer 9 can be directly heated. The area of the thermal radiation device 11 can be configured to be greater than or equal to the area of the wafer 9, thereby enabling uniform heating across the entire surface of the wafer 9. The heating chamber of the present disclosure may be applicable to thermal treatment processes such as reflow. Since the reaction chamber and the heating chamber are connected, various semiconductor processes (such as deposition and etching) and thermal treatment processes can be completed within a single process chamber, thereby improving semiconductor manufacturing efficiency.

In some examples, to simplify the device structure, reduce the device footprint, and lower equipment costs, the heating chamber 2 also stores a shutter disk 10. That is, the heating chamber 2 is configured both to perform thermal treatment processes and to store the shutter disk 10.

Typically, a process chamber is equipped with a shutter disk 10 and a shutter disk garage configured to store the shutter disk 10. When a new target is used for processing, or when processing is resumed after chamber maintenance, to prevent metal contaminants on the target surface from depositing onto the wafer surface, it is usually necessary to preheat the chamber and sputter off surface contaminants from the target before performing the normal semiconductor process. At this time, the shutter disk 10 is used to cover the area above the base 3. During the normal semiconductor process, the shutter disk 10 needs to be moved to the shutter disk garage that is in communication with the reaction chamber 1. In such cases, in some examples, the shutter disk garage serves as the heating chamber 2. That is, for process chambers already equipped with a shutter disk garage, the original shutter disk garage can be modified by adding the thermal radiation device 11, so that the shutter disk garage is configured both to perform thermal treatment processes and to store the shutter disk 10. This eliminates the need to occupy internal space within the reaction chamber 1 and avoids major structural modifications to the reaction chamber 1, thereby reducing design complexity and saving equipment costs. Furthermore, the volume of the shutter disk garage is smaller than that of the reaction chamber 1, which allows for more concentrated heat distribution and reduced heat loss, thereby improving the heating rate of the wafer 9.

Based on the dual functionality of the heating chamber 2 for both thermal treatment and shutter disk storage, the transmission device 4 is also configured to carry the shutter disk 10 and transmit it between the reaction chamber 1 and the heating chamber 2. In some examples, prior to performing a semiconductor process (such as a metal thin film deposition process) on the wafer within the reaction chamber 1, it is typically necessary to carry out pretreatment processes such as preheating the chamber and sputtering off contaminants from the surface of the target. In such cases, the transmission device 4 is used to transfer the shutter disk 10 stored in the heating chamber 2 to a position above the base 3, so that during the pretreatment process, the shutter disk 10 can shield the base 3 to prevent contamination. When the wafer in the reaction chamber 1 is about to undergo the semiconductor process, the shutter disk 10 is transferred to the heating chamber 2 for storage to ensure the normal execution of the process. That is, before the semiconductor process begins, the shutter disk 10 is first transferred to the heating chamber 2 for storage. Additionally, the transmission device 4 may also be used to transfer the wafer, after the semiconductor process in the reaction chamber 1 is completed, to a position beneath the thermal radiation device 11 within the heating chamber 2, allowing the thermal radiation device 11 to heat the wafer and thereby complete the thermal treatment process. After heating is completed, the wafer is transferred back to the base 3.

In some examples, to further improve heat utilization and enhance heating efficiency, the top wall of the heating chamber 2 is provided with a reflective surface 221. The reflective surface 221 is configured to reflect the heat radiated by the thermal radiation device 11 toward the surface of the wafer 9 located inside the heating chamber 2. Specifically, the reflective surface 221 is disposed on the inner-facing surface of the top wall of the heating chamber 2. Furthermore, in some examples, the reflective surface 221 is a mirror surface, such as an arc-shaped surface with a surface roughness less than or equal to Ra 0.1.

In some examples, the top wall of the heating chamber 2 is provided with a cooling flow channel, which is configured to transport a cooling fluid, such as cooling water, to cool the top wall of the heating chamber 2 during the thermal treatment process. This prevents the outer surface of the top wall from reaching excessively high temperatures that could cause burns to personnel. For example, as shown in FIG. 2, a groove 14 is formed on the outer surface of the top wall of the heating chamber 2, and a cover plate 15 seals the groove 14. The groove 14 and the cover plate 15 together define the aforementioned cooling flow channel. Furthermore, in some examples, the outer surface of the cover plate 15 is flush with the outer surface of the top wall of the heating chamber 2, so that the outer surfaces of the cover plate 15 and the top wall together form a smooth and continuous surface. However, the embodiments of the present disclosure are not limited thereto. In practical applications, the groove 14 may also be formed on the reflective surface 221, and the distribution of the cooling flow channel on the reflective surface 221 or the outer surface of the top wall of the heating chamber 2 may be configured as needed. For instance, the cooling flow channel may be evenly distributed across the reflective surface 221 or the outer surface of the top wall of the heating chamber 2.

In some examples, to further improve heating efficiency, a concave portion 222 is formed on the top wall of the heating chamber 2. The concave portion 222 is specifically formed on the surface of the top wall that faces the interior of the heating chamber 2. The inner surface of the concave portion 222 constitutes the aforementioned reflective surface 221, and its shape is configured to concentrate reflected light toward the surface of the wafer 9 located inside the heating chamber 2, allowing the light to cover the entire surface of the wafer 9 and thereby improving heating uniformity.

The inner surface of the concave portion 222 may take various forms to achieve the above function. For example, the reflective surface 221 comprises a planarized surface 221a and an annular surface 221b surrounding the planarized surface 221a. The planarized surface 221a is parallel to the horizontal plane, and the height of the annular surface 221b decreases from the edge of the planarized surface 221a toward the peripheral edge of the top wall of the heating chamber 2. In other words, the opening size enclosed by the annular surface 221b increases from top to bottom. In this way, the annular surface 221b can reflect the light incident upon it and concentrate the light toward the entire surface of the wafer 9. In some examples, the outer diameter of the annular surface 221b is greater than or equal to the diameter of the wafer 9.

The annular surface 221b may be an annular conical surface. In this case, the inclination angle of the annular conical surface relative to the horizontal plane can be configured to reflect incident light and concentrate it toward the entire surface of the wafer 9, allowing the light to cover the entire wafer surface. Alternatively, the annular surface 221b may be an annular curved surface. In this case, the inclination angle and curvature of the annular curved surface can be configured to reflect incident light and concentrate it toward the entire surface of the wafer 9, allowing the light to fully cover the wafer. For example, the annular curved surface may be a portion of a spherical surface.

In some examples, based on the use of the reflective surface 221, the thermal radiation device 11 comprises an annular light tube. The annular light tube is disposed around the inner side of the annular surface 221b and located outside the edge of the planarized surface 221a. That is, the inner circumference diameter of the annular light tube is greater than the outer circumference diameter of the planarized surface 221a and smaller than the outer circumference diameter of the annular surface 221b. Since the annular light tube is disposed above the wafer 9 in a surrounding manner, it not only increases the amount of heat irradiated onto the surface of the wafer 9 and improves heating efficiency, but also enhances heating uniformity. Additionally, by disposing the annular light tube around the inner side of the annular surface 221b and outside the edge of the planarized surface 221a, more light emitted from the annular light tube can be directed onto the annular surface 221b. This allows the annular surface 221b to reflect the incident light and concentrate it toward the entire surface of the wafer 9, ensuring full coverage. Those skilled in the art may reasonably configure the diameter of the annular light tube and the distance between the annular light tube and the wafer 9 according to actual conditions, so that the light fully covers the surface of the wafer 9 and improves temperature uniformity.

In some examples, the annular light tube may be fixed to the top wall of the heating chamber 2 using a fastening component, such as a snap-fit connector. Furthermore, a lead channel may be provided in the top wall of the heating chamber 2. The lead channel is configured to route the wiring of the annular light tube from the reflective surface 221 to the outside of the heating chamber 2, and electrically connect the wiring to an external power source to supply power to the annular light tube. It should be noted that in the present disclosure, the annular light tube is a single unit. However, the embodiments of the present disclosure are not limited thereto. In practical applications, multiple annular light tubes may be used, arranged concentrically and distributed along different circumferences. Of course, the thermal radiation device 11 may also adopt other shapes of heating light tubes, such as spiral light tubes, strip-shaped light tubes, bulbs, and so on.

In some examples, to facilitate installation of the thermal radiation device 11, the heating chamber 2 comprises a chamber body 21 with an opening at the top, and a reflective plate 22 disposed at the top of the chamber body 21. The reflective plate 22 is sealingly connected to the chamber body 21 to seal the opening. The reflective plate 22 comprises the aforementioned reflective surface 221, and the reflective surface 221 is exposed from the opening into the heating chamber 2. The thermal radiation device 11 may be fixedly connected to the reflective plate 22. Furthermore, in some examples, to achieve sealing between the reflective plate 22 and the heating chamber 2 and ensure airtightness within both the heating chamber 2 and the reaction chamber 1, a first annular convex portion 211 is provided at the opening on the top of the chamber body 21, and a second annular convex portion 223 is provided at the outer peripheral edge of the reflective plate 22. The second annular convex portion 223 is stacked on the first annular convex portion 211, and the two are fixedly connected, for example, by screws. A sealing member 12 is disposed between the first annular convex portion 211 and the second annular convex portion 223 to seal the opening. In this way, the first annular convex portion 211 provides support for the reflective plate 22 and allows for the installation of the sealing member 12. Additionally, in some examples, a positioning structure may be provided between the first annular convex portion 211 and the second annular convex portion 223 to facilitate alignment and installation of the reflective plate 22. The positioning structure may be, for example, at least one positioning pin 13.

In some examples, based on the dual functionality of the heating chamber 2 for both thermal treatment and shutter disk storage, the process chamber further comprises a first lifting apparatus 5 disposed within the heating chamber 2 (e.g., serving as the shutter disk garage). The first lifting apparatus 5 may be a pin-type structure and is configured to support the shutter disk 10 within the heating chamber 2. At least one of the first lifting apparatus 5 and the transmission device 4 is configured to drive the shutter disk 10 disposed thereon to ascend or descend, to transmit the shutter disk 10 between the first lifting apparatus 5 and the transmission device 4. Additionally, in some examples, when the transmission device 4 is about to transfer the wafer into the heating chamber 2, the first lifting apparatus 5 lowers the shutter disk 10 to a first bearing location, which is lower than a second bearing location of the wafer carried by the transmission device 4 within the heating chamber (i.e., the shutter disk 10 is disposed below the wafer's position during thermal treatment). This ensures that the wafer is positioned above the shutter disk 10 and beneath the thermal radiation device 11, preventing obstruction during wafer transfer. At this point, the thermal radiation device 11 can radiate heat from the top of the heating chamber 2 toward the wafer, completing the thermal treatment.

In some examples, based on the dual functionality of the heating chamber 2 for both thermal treatment and shutter disk storage, the process chamber further comprises a second lifting apparatus 6 disposed within the reaction chamber 1. The second lifting apparatus 6 may be a pin-type structure and is configured to support the wafer 9 within the reaction chamber 1. At least one of the second lifting apparatus 6 and the base 3 is configured to drive the wafer 9 disposed thereon to ascend or descend, to transmit the wafer 9 between the second lifting apparatus 6 and the base 3.

At least one of the first lifting apparatus 5 and the second lifting apparatus 6 may comprise at least three pins spaced apart circumferentially. For example, as shown in FIG. 2, the first lifting apparatus 5 comprises at least three first pins 51 (only two are schematically shown in FIGs. 1 and 2). The tips of the first pins 51 collectively form a first support surface for the shutter disk 10 or wafer 9. The center of the circle formed by the first pins 51 is aligned with the center position of the wafer carried by the transmission device 4 in the heating chamber 2. The first and/or second lifting apparatuses are vertically movable. Taking the first lifting apparatus 5 as an example, the first lifting apparatus 5 comprises a lifting actuator 52 connected to the first pins 51, as shown in FIG. 2. Under the drive of the lifting actuator 52, the first pins 51 can synchronously rise or fall. For the second lifting apparatus 6, its at least three second pins 61 (only two are schematically shown in FIG. 1) may extend through the base 3 and are spaced circumferentially around the base 3.

Taking the case where the first lifting apparatus 5, second lifting apparatus 6, and base 3 are all vertically movable: before the semiconductor process begins, the shutter disk 10 is placed in the heating chamber 2 and supported by the first lifting apparatus 5 (i.e., supported by the first pins 51) at the first bearing location (as shown in FIGs. 1 and 2). At this time, the base 3 is at a transfer location (as shown in FIG. 1), and a second support surface of the second lifting apparatus 6 (formed by the tips of the at least three second pins 61) is higher than the base 3. A robotic arm or other transfer device places the wafer 9 onto the second support surface of the second lifting apparatus 6 in the reaction chamber 1. Then, the base 3 rises to a process location (above the second support surface of the second lifting apparatus 6 as shown in FIG. 1). During the lifting of base 3, it lifts the wafer 9 so that the wafer 9 disengages from the second lifting apparatus 6 and rises together with base 3. Once the base 3 reaches the process location, the semiconductor process can begin. After the semiconductor process is complete, the base 3 descends to the transfer location. During descent, the second lifting apparatus 6 supports the wafer 9, allowing the wafer 9 to separate from the base 3, which then descends alone. At the transfer location, the transmission device 4 positions its bearing portion beneath the wafer 9 and above the base 3. The second lifting apparatus 6 then descends, placing the wafer 9 onto the bearing portion of the transmission device 4, thereby completing the handoff from the second lifting apparatus 6 to the transmission device 4.

When a thermal treatment process such as reflow is needed, the transmission device 4 transfers the wafer 9 to the second bearing location (as shown in FIG. 2), which is above the first bearing location of the shutter disk 10. At this point, the wafer 9 is above the shutter disk 10 and beneath the thermal radiation device 11, allowing heat to be radiated onto the wafer for thermal treatment. After thermal treatment, the transmission device 4 transfers the wafer 9 back to the reaction chamber 1. The second lifting apparatus 6 rises, lifting the wafer 9 off the transmission device 4 and completing the handoff from the transmission device 4 to the second lifting apparatus 6. At this point, the wafer 9 that has undergone thermal treatment is ready for the next step in the semiconductor process.

When it is necessary to sputter a new target or preheat the chamber, the first lifting apparatus 5 raises the shutter disk 10. The transmission device 4 moves its bearing portion beneath the shutter disk 10 in the shutter disk garage (i.e., heating chamber 2), and the first lifting apparatus 5 lowers the shutter disk 10 onto the bearing portion of the transmission device 4, completing the handoff from the first lifting apparatus 5 to the transmission device 4. Then, the transmission device 4 transfers the shutter disk 10 into the reaction chamber 1, positioning the shutter disk 10 above the base 3 (which is at the transfer location) to shield the base and prevent contamination.

It should be noted that in practical applications, the first lifting apparatus 5 may be omitted. Other methods may be used to allow the transmission device 4 to rotate independently into the reaction chamber 1 without carrying the shutter disk 10, for example, manually removing the shutter disk during chamber opening.

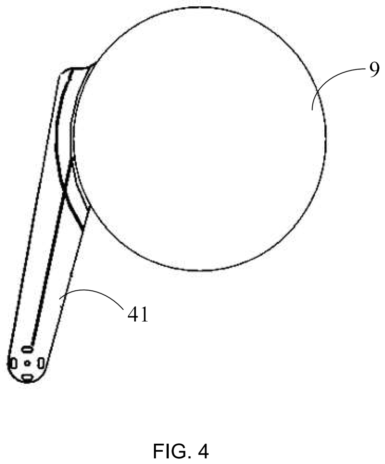

In some examples, as shown in FIGs. 1, 3, and 4, the transmission device 4 comprises a transmission arm and a second driving source 43. The transmission arm is used to carry the shutter disk 10 or wafer 9, and the second driving source 43 drives the transmission arm to move between the reaction chamber 1 and the heating chamber 2. For example, the transmission arm may comprise a vertically oriented rotating shaft 42, and a connecting arm 41 and a bearing portion 44 perpendicular to the rotating shaft 42. The bearing portion 44 comprises a bearing surface for carrying the wafer or shutter disk. The lower end of the rotating shaft 42 is connected to the second driving source 43, which drives the rotating shaft 42 to rotate about its axis. The second driving source 43 may be a motor, cylinder, or hydraulic actuator. In some examples, the second driving source 43 is located outside the reaction chamber 1. In this case, the lower end of the rotating shaft 42 extends from the bottom of the reaction chamber 1 to the outside and connects to the second driving source 43.

The upper end of the rotating shaft 42 connects to a first end of the connecting arm 41, and a second end of the connecting arm 41 connects to the bearing portion 44. Under the drive of the second driving source 43, the rotating shaft 42 rotates the connecting arm 41 and bearing portion 44 synchronously, allowing the bearing portion 44 to rotate into either the reaction chamber 1 or the heating chamber 2. It should be noted that if the transmission device 4 also supports vertical movement, a lifting driving source may be added to drive the transmission arm vertically. In some examples, the lifting driving source may be connected to the second driving source 43 to move both the second driving source 43 and the transmission arm vertically. Alternatively, the lifting driving source may be connected only to the transmission arm to move it independently. In the latter case, the second driving source 43 drives the lifting driving source to rotate together with the transmission arm as a single assembly.

The bearing portion 44 is used to carry the shutter disk 10 or wafer. In some examples, the contour of the bearing portion 44 in its horizontal projection is configured such that the bearing portion 44 does not collide with the first lifting apparatus 5 when moving into the heating chamber 2, nor with the second lifting apparatus 6 when moving into the reaction chamber 1.

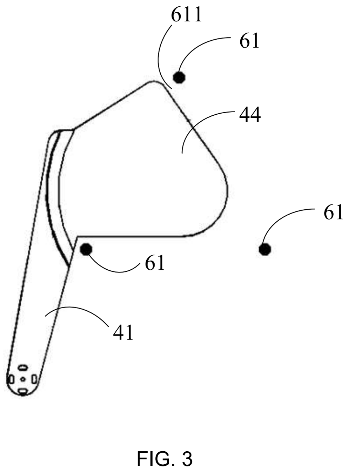

In the case where the second lifting apparatus 6 comprises multiple second pins 61 spaced apart circumferentially, as shown in FIG. 3, when the bearing portion 44 carries the shutter disk 10 or wafer and moves into the reaction chamber 1, at least part of the bearing portion 44 can pass through the gap 611 between adjacent second pins 61 and enter the space enclosed by the multiple second pins 61, allowing the shutter disk 10 or wafer to be positioned above the base 3. Similarly, when the first lifting apparatus 5 comprises multiple first pins 51 spaced apart circumferentially, and the bearing portion 44 carries the shutter disk 10 or wafer into the heating chamber 2, at least part of the bearing portion 44 can pass through the gap between adjacent first pins 51 and enter the space enclosed by the multiple first pins 51, positioning the shutter disk 10 or wafer beneath the thermal radiation device 11. Specifically, when the bearing portion 44 carries the wafer into the heating chamber 2, at least part of the bearing portion 44 can pass through the gap between adjacent first pins 51 and enter the space enclosed by the multiple first pins 51, at which time, the wafer 9 is located above the shutter disk 10 and beneath the thermal radiation device 11. One example of a contour shape of the bearing portion 44 that enables the above functionality is shown in FIG. 3. Of course, the structure of the bearing portion 44 shown in FIG. 3 is merely illustrative. In practical applications, the transmission arm may adopt any contour shape, as long as it avoids collision with the first lifting apparatus 5 and the second lifting apparatus 6.

An embodiment of the present disclosure provides a semiconductor processing apparatus, comprising a process chamber as described in any one of the examples provided in the first embodiment of the present disclosure.

The semiconductor processing apparatus provided in the present disclosure improves wafer heating efficiency and uniformity by utilizing the process chamber described herein.

In some examples, the semiconductor processing apparatus comprises a physical vapor deposition device. Within the process chamber of the physical vapor deposition device, the reaction chamber 1 is configured to perform thin film deposition (e.g., metal films) on the wafer, while the heating chamber 2 is configured to carry out thermal treatment processes on the deposited films, such as metal film reflow.

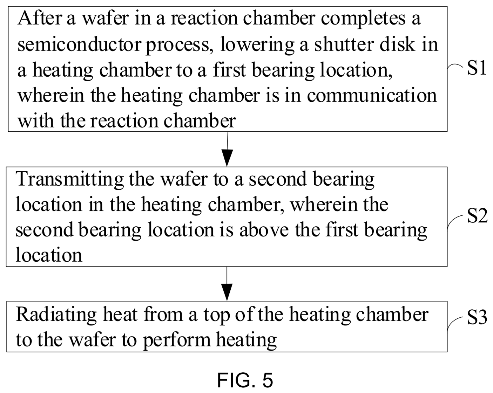

An embodiment of the present disclosure provides a thin film deposition method. With reference to FIGs 1, 2, and 5, the thin film deposition method comprises steps S1 to S3.

S1 comprises after the wafer 9 in the reaction chamber 1 completes the semiconductor process, lowering the shutter disk 10 in the heating chamber 2 to the first bearing location. The heating chamber 2 is in communication with the reaction chamber 1.

S2 comprises transmitting the wafer 9 to the second bearing location in the heating chamber 2. The second bearing location is above the first bearing location.

S3 comprises radiating heat from the top of the heating chamber 2 to the wafer 9 to perform heating.

The thin film deposition method provided in the present disclosure utilizes the heating chamber 2 for both thermal treatment and shutter disk storage. This dual functionality simplifies the equipment structure, reduces footprint, and lowers equipment cost. Before performing thermal treatment processes such as metal reflow, the wafer can be transferred from the reaction chamber 1 to the heating chamber 2, where heat is radiated from the top of the heating chamber 2 onto the wafer 9 to complete the thermal treatment. In the present disclosure, the wafer is heated inside the heating chamber 2. Since the volume of the heating chamber 2 can be configured to be smaller than that of the reaction chamber 1, the heat distribution can be more concentrated and heat loss can be reduced, thereby improving the wafer heating rate. Meanwhile, by disposing the thermal radiation device at the top of the heating chamber 2, the upper surface of the wafer 9 can be directly heated, further enhancing the wafer heating rate.

Specifically, taking the process chamber shown in FIG. 1 as an example, where the first lifting apparatus 5, second lifting apparatus 6, and base 3 are all vertically movable, before the semiconductor process begins, the shutter disk 10 is placed in the heating chamber 2 and supported by transmission device 4, at which time, the base 3 is at the transfer location, and the second support surface of the second lifting apparatus 6 is higher than the base 3. A robotic arm or other transfer device places the wafer 9 onto the second support surface of the second lifting apparatus 6 in the reaction chamber 1. Then, the base 3 rises to the process location (above the second support surface of the second lifting apparatus 6), lifting the wafer 9 off the second lifting apparatus 6 and carrying the wafer 9 upward. At this point, the semiconductor process can be performed in the reaction chamber 1.

After the semiconductor process is complete, the base 3 descends to the transfer location. During descent, the second lifting apparatus 6 supports the wafer 9, allowing the wafer 9 to separate from the base 3, which then descends alone. Next, step S1 is carried out: the shutter disk 10 in the heating chamber 2 is lowered to the first bearing location. Specifically, the first lifting apparatus 5 rises, lifting the shutter disk 10 away from the transmission device 4 and completing the handoff from the transmission device 4 to the first lifting apparatus 5. This allows the transmission device 4 to move its bearing portion beneath the wafer 9, which is currently supported by the second lifting apparatus 6. The first lifting apparatus 5 then descends, placing the shutter disk 10 at the first bearing location in the heating chamber 2. Following that, the second lifting apparatus 6 lowers, allowing the wafer 9 to settle onto the bearing surface of the bearing portion of the transmission device 4, thereby completing the handoff from the second lifting apparatus 6 to the transmission device 4. Step S2 is then executed: the transmission device 4 transfers the wafer 9 to the second bearing location in the heating chamber 2, which is positioned above the first bearing location of the shutter disk 10. At this time, the wafer 9 is located above the shutter disk 10 and below the thermal radiation device 11. Step S3 is then performed, in which the thermal treatment process takes place within the heating chamber 2.

After thermal treatment, the transmission device 4 transfers the wafer 9 back to the reaction chamber 1. The second lifting apparatus 6 rises, lifting the wafer 9 off the transmission device 4 and completing the handoff from the transmission device 4 to the second lifting apparatus 6. At this point, the wafer 9 that has undergone thermal treatment is ready for the next step in the semiconductor process.

In summary, the disclosure provides a process chamber, a semiconductor processing apparatus, and a thin film deposition method. According to this disclosure, the transmission device can carry the wafer and transmit it from the reaction chamber to the heating chamber before performing a thermal treatment process such as the metal reflow process. During the thermal treatment process, the thermal radiation device disposed at the top of the heating chamber radiates heat toward the wafer inside the heating chamber, thereby heating the wafer and completing the thermal treatment process. In the present disclosure, the wafer is heated inside the heating chamber. Since the volume of the heating chamber can be configured to be smaller than that of the reaction chamber, the heat distribution can be more concentrated and heat loss can be reduced, thereby improving the wafer heating rate. Meanwhile, by disposing the thermal radiation device at the top of the heating chamber, the upper surface of the wafer can be directly heated, further enhancing the wafer heating rate.

It is understood that the above examples are provided solely to illustrate the principles of the present disclosure and are not intended to limit its scope. Various modifications and improvements may be made by those skilled in the art without departing from the spirit and essence of the application, and such modifications are considered within the scope of the present disclosure.

## Claims

1. A process chamber, comprising:
a reaction chamber, comprising a base for carrying a wafer horizontally;
a heating chamber, which is in communication with the reaction chamber, wherein a thermal radiation device is provided at a top of the heating chamber and is configured for radiating heat toward an interior of the heating chamber; and
a transmission device, disposed in the reaction chamber, wherein the transmission device is configured to transmit the wafer between the reaction chamber and the heating chamber.

2. The process chamber according to claim 1, wherein a shutter disk is stored in the heating chamber, and wherein the transmission device is further configured to carry the shutter disk and transmit the shutter disk between the reaction chamber and the heating chamber.

3. The process chamber according to claim 2, wherein the transmission device is further configured to transmit the shutter disk above the base before a semiconductor process is performed on the wafer in the reaction chamber, and to transmit the shutter disk back to store in the heating chamber when the wafer begins to undergo the semiconductor process; or
wherein the transmission device is further configured to transmit the wafer below the thermal radiation device after the wafer completes the semiconductor process to enable the thermal radiation device to heat the wafer, and to transmit the wafer back onto the base after the thermal radiation device finishes heating the wafer.

4. The process chamber according to any one of claims 1 to 3, wherein a top wall of the heating chamber is provided with a reflective surface, and the reflective surface is configured to reflect heat radiated by the thermal radiation device to a surface of the wafer located in the heating chamber.

5. The process chamber according to claim 4, wherein a cooling flow channel is arranged on the top wall of the heating chamber, wherein the cooling flow channel is configured to transmit a cooling fluid.

6. The process chamber according to claim 4, wherein a concave portion is formed on the top wall of the heating chamber, an inner surface of the concave portion forms the reflective surface, and wherein a shape of the inner surface of the concave portion is configured to enable reflected light to converge toward the surface of the wafer located in the heating chamber, such that the reflected light covers the entire surface of the wafer.

7. The process chamber according to claim 6, wherein the reflective surface comprises a planarized surface and an annular surface surrounding the planarized surface, wherein the planarized surface is parallel to a horizontal plane, and wherein a height of the annular surface decreases from an edge of the planarized surface toward a peripheral edge of the top wall of the heating chamber.

8. The process chamber according to claim 7, wherein the thermal radiation device comprises at least one annular light tube, and the annular light tube is disposed around an inner side of the annular surface and located outside the edge of the planarized surface.

9. The process chamber according to claim 4, wherein the heating chamber comprises a chamber body having an opening at its top, and a reflective plate disposed at the top of the chamber body, wherein the reflective plate is seamlessly connected to the chamber body for sealing the opening, wherein the reflective plate has the reflective surface, and the reflective surface is exposed from the opening into the heating chamber.

10. The process chamber according to claim 9, wherein a first annular convex portion is provided at the opening at the top of the chamber body, a second annular convex portion is provided at an outer peripheral edge of the reflective plate, the second annular convex portion is stacked on the first annular convex portion, and the first annular convex portion is fixedly connected to the second annular convex portion;
wherein a sealing member is further disposed between the first annular convex portion and the second annular convex portion for sealing the opening.

11. The process chamber according to claim 2, further comprising a first lifting apparatus disposed in the heating chamber, wherein the first lifting apparatus is configured to carry the shutter disk in the heating chamber;
wherein at least one of the first lifting apparatus and the transmission device is configured to drive the shutter disk disposed thereon to ascend or descend, to transmit the shutter disk between the first lifting apparatus and the transmission device.

12. The process chamber according to claim 11, wherein when the transmission device is to transmit the wafer to the heating chamber, the first lifting apparatus is configured to drive the shutter disk disposed thereon to descend below a location where the wafer is to be carried to by the transmission device within the heating chamber.

13. The process chamber according to claim 11, further comprising a second lifting apparatus disposed in the reaction chamber, wherein the second lifting apparatus is configured to ascend and descend the wafer in the reaction chamber;
wherein at least one of the second lifting apparatus and the base is configured to drive the wafer disposed thereon to transmit the wafer between the second lifting apparatus and the base.

14. The process chamber according to claim 13, wherein the transmission device comprises a transmission arm, a second driving source, and a lifting driving source, wherein the transmission arm is configured to carry the shutter disk or the wafer, and the second driving source is configured to drive the transmission arm to move between the reaction chamber and the heating chamber; wherein the lifting driving source is configured to drive the transmission arm vertically;
wherein the transmission arm comprises a rotating shaft disposed along a vertical direction and a connecting arm and a bearing portion perpendicular to the rotating shaft, wherein a lower end of the rotating shaft is connected to the second driving source, an upper end of the rotating shaft is connected to a first end of the connecting arm, and a second end of the connecting arm is connected to the bearing portion;
wherein the second lifting apparatus comprises pins arranged at intervals along a circumferential direction of the base, and when the bearing portion carries the shutter disk or the wafer to move into the reaction chamber, at least a part of the bearing portion moves into a space enclosed by the pins from an interval between adjacent pins of the second lifting apparatus, such that the shutter disk or the wafer is located above the base; or
wherein the first lifting apparatus comprises pins arranged at intervals along a circumferential line, and when the bearing portion carries the shutter disk or the wafer to move into the heating chamber, at least a part of the bearing portion moves into a space enclosed by the pins from an interval between adjacent pins of the first lifting apparatus, such that the shutter disk or the wafer is located below the thermal radiation device.

15. A semiconductor processing apparatus, comprising a process chamber according to any one of claims 1 to 14.

16. The semiconductor processing apparatus according to claim 15, wherein the semiconductor processing apparatus comprises a physical vapor deposition device.

17. A thin film deposition method, comprising:
after a wafer in a reaction chamber completes a semiconductor process, lowering a shutter disk in a heating chamber to a first bearing location, wherein the heating chamber is in communication with the reaction chamber;
transmitting the wafer to a second bearing location in the heating chamber, wherein the second bearing location is above the first bearing location; and
radiating heat from a top of the heating chamber to the wafer to perform heating.
